# EUROPEAN PATENT APPLICATION

(11) **EP 1 785 504 A2**
(43) Date of publication of application: **16.05.2007**
(21) Application number: 06122625.4
(22) Date of filing: 19.10.2006
(51) Int. Cl.: C23C 14/06, C23C 14/34, C23C 30/00

(54) **Surface-coated article, production method therefor, machine tool, and machine tool apparatus**

(30) Priority: 11.11.2005 JP 2005327374
(71) Applicant: Mitsubishi Heavy Industries, Ltd., 108-8215 Tokyo (JP)
(72) Inventor: Nagano, Ichiro, Yokohama, Kanagawa-ken 236-8515 (JP); Kikuchi, Taiji, Shiga-ken 520-3080 (JP); Fujita, Masakatsu, Shiga-ken 520-3080 (JP); Kodama, Yukio, Shiga-ken 520-3080 (JP); Yasui, Toyoaki, Hiroshima, Hiroshima-ken 733-8553 (JP); Murakami, Yuichiro, Yokohama, Kanagawa-ken 231-8715 (JP)
(74) Representative: Henkel, Feiler & Hänzel

(57) **Abstract**

The present invention provides a surface-coated article possessing a high hardness coating that has a Vickers hardness that is equal to or greater than that of conventional high hardness coatings, and which has an oxidation initiation temperature, which is an expression of resistance to oxidation, that is higher than that of conventional high hardness coatings. A coating layer containing a compound nitride that employs as main components Al and at least one element selected from the group consisting of Zr, Hf, Pd, Ir and the rare earth elements is formed on or over a base material.

## Description

### BACKGROUND OF THE INVENTION

### 1. FIELD OF THE INVENTION

The present invention relates to a surface-coated article having excellent oxidation resistance which is made by forming a high hardness coating onto a base material, to a production method therefore, and to a machine tool and a machine tool apparatus.

This application is based on Japanese Patent Application No. 2005-327374, the content of which is incorporated herein by reference.

### 2. DESCRIPTION OF RELATED ART

Technologies have been developed for forming a high hardness coating onto a base material using such physical vapor deposition techniques as ion plating and the like, and these have been suitably employed in machine tools such as seen in TiN coatings. However, since these coatings start to oxidize at temperatures of around 500°C, they are problematic since they cannot be used in machine tools subject to cutting conditions that expose the tools to high temperatures. The TiAlN-based high hardness coatings subsequently developed do not oxidize even at temperatures of approximately 800°C, and can therefore be used at temperatures of up to several hundred degrees Celsius. Moreover, in recent years, AlCrN-based coatings have been developed as coatings that can be used under cutting conditions where even higher temperatures are reached (see Japanese Patent Application, First Publication No. 10-25566 and Japanese Patent Application, First Publication No. 2003-321764, for example). Namely, high hardness coatings that do not oxidize even at high temperatures of approximately 1000°C to 1200°C have been proposed, and these coatings are applicable the machine tool is subject to even more stringent cutting conditions.

In recent years, from the perspective of environmental safety and cost savings, there has been demand in the area of gear cutting work for manufacturing automobile component parts for example, for so-called dry cutting work which does not employ a cutting oil. Since the cutting tools used in this dry cutting work are used without a cutting oil, they are subject to more stringent cutting conditions. In order to meet these stringent conditions, a high hardness coating is required that has a hardness that is equal or superior to that of conventional high hardness coatings, and which has a resistance to oxidation that is greater than that of the conventional high hardness coatings.

### BRIEF SUMMARY OF THE INVENTION

In order to resolve the above-described problems, the present invention aims to provide a surface-coated article possessing a high hardness coating that has a Vickers hardness (Hv) that is equal to or greater than that of conventional high hardness coatings, and which has an oxidation initiation temperature, which is an expression of resistance to oxidation, that is higher than that of conventional high hardness coatings.

In order to resolve the above problems, the present invention employs the following solutions.

Namely, a surface-coated article according to the present invention comprises a base material and a high hardness coating that is formed on or over this base material. The high hardness coating comprises a coating layer that contains a compound nitride that employs as main components Al and at least one element selected from the group consisting of Zr, Hf, Pd, Ir and the rare earth elements.

The high hardness coating of this surface-coated article provides both high hardness and superior resistance to oxidation.

A surface-coated article according to the present invention may also be one comprising a base material and a high hardness coating that is formed on or over this base material, wherein the high hardness coating comprises a coating layer that contains a compound nitride that has as its main components Al, Si, and at least one element from the group consisting of Zr, Hf, Pd, Ir and the rare earth elements.

The high hardness coating of this surface-coated article provides superior resistance to wear, in addition to high hardness and excellent resistance to oxidation.

With regard to the compound nitride in the coating layer of the surface-coated article according to the present invention, it is preferable that Zn be included in the range of 10 to 50 atomic percent of the electropositive element component, with the balance comprising Al and unavoidable impurities. (Except as otherwise stated hereinafter, "percent" or "%", which indicates the amount of component contained in the compound nitride, indicates the atomic percentage of the electropositive element component only.)

A Zn content of less than 10% is undesirable as it is not possible to obtain sufficient hardness. Likewise, a Zn content in excess of 50% is not desirable as the resistance to oxidation falls.

Moreover, when the compound nitride in the coating layer in the surface-coated article according to the present invention contains Si as one of the main components, then it is preferable that the amount of Si contained be in the range of 1 to 30%.

When the amount of Si is less than 1%, the adhesiveness of the coating layer falls. As a result, the effect of improved wear resistance is reduced. Further, when the amount of Si contained exceeds 30%, then the resistance to oxidation is not sufficient. Moreover, since the adhesive property deteriorates even further in this case, wear resistance also becomes inadequate, so this is not desirable.

It is preferable to provide a bonding layer between the base material and the coating layer in the surface-coated article according to the present invention, this bonding layer containing at least one of nitrides, carbides, and carbonitrides of at least one type of element selected from the group consisting of Zr, Ti and Cr.

By providing this type of bonding layer, the adhesive properties between the base material and the coating layer increases, such that it becomes more difficult for the coating layer to peel away. As a result, the wear resistance of the high hardness coating in the surface-coated article according to the present invention is improved.

It is also preferable to provide an intermediate layer that contains a component of the bonding layer and a component of the coating layer between the bonding layer and the coating layer.

By providing this type of intermediate layer, the adhesiveness between the bonding layer and the coating layer increases and it becomes even more difficult for the coating layer to peel away. As a result, the wear resistance of the high hardness coating of the surface-coated article according to the present invention is even further improved.

In the surface-coated article according to the present invention, it is preferable that the base material be a high-speed tool steel or a cemented carbide.

When a high-speed tool steel or a cemented carbide is employed as the base material in this way, the surface-coated article according to the present invention can be suitably employed as a tool having a high degree of hardness and superior resistance to oxidation.

It is preferable that each of the layers of the high hardness coating in the surface-coated article according to the present invention be formed using a physical vapor deposition method such as ion plating, high-frequency sputtering or the like.

A coating that is formed using a physical vapor deposition method has superior adhesive properties, so that a high hardness coating that is superior with respect to resistance to wear can be obtained. In particular, when a high hardness coating is formed using an arc ion plating method, even more superior coating adhesion can be obtained, so that this is even more preferred.

In the production method for a surface-coated article according to the present invention, the base material is supported inside an airtight container by a holder disposed therein; a target for forming a coating layer containing an alloy or nitride thereof having as main components A1 and at least one type of element selected from the group consisting of Zr, Hf, Pd, Ir and the rare earth elements, is disposed inside the container; nitrogen is supplied into the container; and, with the target for forming the coating layer designated as the anode and the holder designated as the cathode, an electrical discharge is generated between the target for forming the coating layer and the holder, causing the coating layer to be formed onto the base material.

By means of this production method, a surface-coated article possessing a high hardness coating which has both high hardness and superior resistance to oxidation can be produced.

The target for forming the coating layer in this method for producing a surface-coated article according to the present invention may contain an alloy or a nitride thereof having as main components Al, Si and at least one type of element selected from the group consisting of Zr, Hf, Pd, Ir and the rare earth elements.

When a target for forming this coating layer is employed, a surface-coated article can be produced which possesses a high hardness coating having superior resistance to wear in addition to high hardness and excellent resistance to oxidation.

In the method for producing a surface-coated article according to the present invention, it is preferable that the compound nitride in the coating layer contain Zr in the range of 10 to 50%, with the balance comprising A1 and unavoidable impurities.

When the Zn content is less than 10%, a coating having sufficient hardness cannot be formed, so that this is undesirable. Likewise, when the Zn content exceeds 50%, a coating which has low resistance to oxidation is formed, so that this is not desirable.

In the method for producing a surface-coated article according to the present invention, it is preferable that when the compound nitride in the coating layer contains Si as one of the main components, the amount of Si contained be in the range of 1 to 30%.

When the amount of Si is less than 1%, the adhesiveness of the coating layer falls. As a result, the effect of improving the wear resistance of the high hardness coating that is formed is small. Further, when the amount of Si contained exceeds 30%, then the high hardness coating that is formed has inadequate resistance to oxidation. Moreover, since the adhesive properties deteriorate even more in this case, wear resistance becomes inadequate as well, which is not desirable.

In the method for producing a surface-coated article according to the present invention, a bonding layer may first be formed to the base material, after which the aforementioned coating layer may be formed on or over this bonding layer. The bonding layer is formed by disposing a target for this purpose inside the aforementioned container, this target for forming the bonding layer containing as a main component at least one element selected from the group consisting of Zr, Ti, and Cr; supplying at least one of nitrogen and hydrocarbons into the container; and, with the target for forming the bonding layer designated as the anode and the holder designated as the cathode, generating an electrical discharge between the holder and the target for forming the bonding layer.

By providing a step for forming this type of bonding layer, the adhesiveness between the base material and the coating layer is improved, so that a coating layer that does not readily peel away is formed. As a result, a surface-coated article having high hardness coating of superior wear resistance can be produced.

In addition, after forming the bonding layer, it is acceptable to form an intermediate layer on or over the bonding layer, and then form the coating layer on or over this intermediate layer. This intermediate layer can be formed by employing the target for forming the bonding layer and the target for forming the coating layer as anodes and employing the holder as a cathode, and then causing an electrical discharge between the holder and the respective targets.

By providing a step for forming this type of intermediate layer, the adhesiveness between the bonding layer and the coating layer is increased, forming a coating layer which is even more resistant to peeling. As a result, it is possible to form a surface-coated article possessing a high hardness coating that has an even more superior resistance to wear.

The machine tool according to the present invention consists of a base material used for machine tools and the high hardness coating according to the present invention which is formed onto this base material.

Because the aforementioned high hardness coating has been formed to the surface of this machine tool, this machine tool is provided with high hardness and superior resistance to oxidation. More particularly, when the compound nitride in the coating layer of the high hardness coating contains Si, then this machine tool also possesses superior wear resistance.

The machine tool according to the present invention is particularly suitable as a cutting tool.

Specifically, when the machine tool according to the present invention is employed as a cutting tool, it is possible to achieve workability and longer durability at high cutting speeds. In addition, the machine tool according to the present invention is suitable for use as a tool used in dry cutting work where a cutting oil is not used. The cutting tool according to the present invention is suitably employed as a hob cutter, pinion cutter, broach or other such gear cutting tool.

The machine tool apparatus according to the present invention is provided with the above-described machine tool according to the present invention. A cutting apparatus employing the above-described cutting tool is a representative example of the machine tool apparatus.

This cutting apparatus is suitably employed in cutting work where high hardness and superior resistance to oxidation and wear are required of the cutting tool. Accordingly, the present invention makes it possible to realize a machine tool that enables working at high cutting speeds and has a high work efficiency. In addition, this cutting apparatus is suitably employed as a cutting apparatus for carrying out dry cutting work in which a cutting oil is not used. Further, the cutting apparatus according to the present invention can be suitably used as a hobbing machine or other such gear cutting apparatus.

The surface-coated article according to the present invention possesses a high hardness coating that is provided with both high hardness and superior resistance to oxidation. As a result, it is suitably employed as a machine tool or die, and is highly useful in industry. Moreover, in addition to the high hardness and superior resistance to oxidation, the surface-coated article according to the present invention has a high hardness coating that possesses excellent wear resistance as a result of its high adhesive properties. As a result, it is suitably employed as a cutting tool used in dry cutting work where a cutting oil is not employed. In particular, the surface-coated article according to the present invention can be suitably employed as a hob cutter, pinion cutter, broach or other such gear cutting machine tool in which the base material is a high-speed tool steel or carbide member.

By means of the production method for a surface-coated article according to the present invention, a surface-coated article is produced that has a high hardness coating provided with both high hardness and superior oxidation resistance. Accordingly, the production method for the surface-coated article according to the present invention is suitably employed to produce machine tools or dies. Further, by employing the production method for a surface-coated article according to the present invention, a surface-coated article is produced that has a high hardness coating which possesses superior wear resistance, as well as high hardness and superior resistance to oxidation. Accordingly, the production method for a surface-coated article according to the present invention can be suitably employed in the production of cutting tools for use in dry cutting work where a cutting oil is not employed. In particular, the production method for a surface-coated article according to the present invention is suitably employed in the production of hob cutters or other such gear cutting machine tools. The aforementioned cutting tool is suitable as a cutting tool that is attached to a cutting apparatus used in dry cutting work. Since this type of cutting apparatus does not employ cutting oil, it is superior with respect to environmental safety and cost.

### BRIEF DESCRIPTION OF THE SEVERAL VIEWS OF THE DRAWINGS

FIG. 1 is a schematic cross-sectional view showing a first embodiment of the surface-coated article according to the present invention.
FIG. 2 is a schematic cross-sectional view showing a second embodiment of the surface-coated article according to the present invention.
FIG. 3 is a schematic cross-sectional view showing a third embodiment of the surface-coated article according to the present invention.
FIG. 4 is a schematic view of the arc ion plating apparatus that is employed in the first through third embodiments of the present invention.

### DETAILED DESCRIPTION OF THE INVENTION

Embodiments and effects of the present invention will now be explained below.

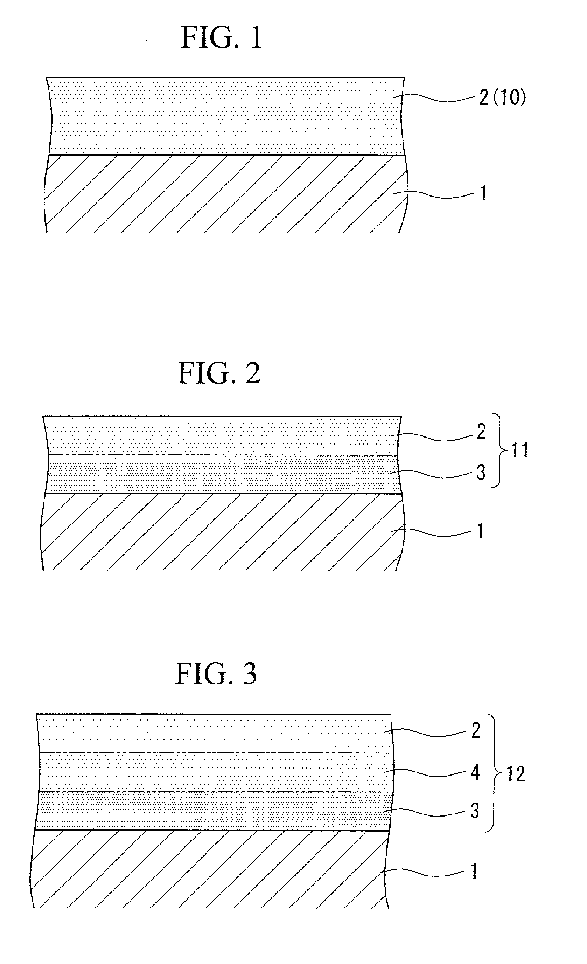

FIG. 1 is a schematic cross-sectional view showing a first embodiment of the surface-coated article according to the present invention.

The surface-coated article according to this embodiment has a base material 1, which is the material to be treated, and a coating layer 2, which contains a composite nitride which employs as its main components A1 and Zn, or Al, Zr and Si, for the high hardness coating 10 that is formed to the surface of the base material 1. A high-speed tool steel or a cemented carbide, such as tungsten carbide (WC) for example, may be used for the base material 1. Unlike conventional high hardness coatings, a AlZrN-based coating or a AlZrSiN-based coating does not contain components such as CrN which break down easily at high temperatures. As a result, the oxidation initiation temperature of AlZrN- and AlZrSiN-based coatings is 1250°C or more.

In the above-described surface-coated article, it is preferable that the composite nitride in the coating layer 2 contains Zr in the range of 10% to 50%. When the amount of contained Zr is less than 10%, the Vickers hardness (Hv) falls. When the amount of contained Zr exceeds 50%, the coating peels easily due to oxidation. Moreover, from the perspective of material costs, it is better not to include more Zr than is necessary.

Si is required in order to improve the adhesive properties of the coating. In this case, it is preferable to include Si in the range of 1% to 30%. When the amount of contained Si is less than 1%, the adhesive properties are not adequate and the coating tends to peel easily. When the amount of contained Si exceeds 30%, the coating becomes fragile and weakens with respect to impacts, leading to peeling.

In the composite nitride in the coating layer 2, it is possible to substitute a portion or all of the Zr with an element selected from the group consisting of Hf, Pd, Ir or such rare earth elements as Er, Ho and Dy at an atomic ratio of 1:1. Note that even when a portion or all of the Zr is substituted with the aforementioned other elements, there is almost no change in the hardness, or resistance to oxidation and wear of the coating layer 2. Since Zn is the cheapest from among the aforementioned elements, however, it is preferable to employ the composite nitride without substituting the Zr.

FIG. 2 is a schematic cross-sectional view showing a second embodiment of the surface-coated article according to the present invention.

In the surface-coated article according to the second embodiment, a layer consisting of a nitride of at least one type of element from among Zr, Ti, Cr and the like, is provided as a bonding layer 3 between the coating layer 2 and the base material 1 according to the first embodiment above. In place of the aforementioned nitride, this bonding layer 3 may also be a carbide, carbonitride or mixed phase of these. In this second embodiment, the bonding layer 3 is formed onto the base material 1 by means of a physical vapor deposition method, and the coating layer 2 consisting of the composite nitride is formed onto this, thereby completing a high hardness coating 11. The bonding layer 3 functions to improve the adhesive properties between the base material 1 and the coating layer 2, and prevents peeling of the high hardness coating 11 when coating 11 is subjected to a high load.

FIG. 3 is a schematic cross-sectional view of a third embodiment of the surface-coated article according to the present invention. In this embodiment, a bonding layer 3 is formed onto the base material 1 by means of a physical vapor deposition method, an intermediate layer 4 containing components of the bonding layer 3 and the coating layer 2 is formed onto the bonding layer 3, and the coating layer 2 consisting of a composite nitride is formed onto the intermediate layer 4, thereby completing the high hardness coating 12. This intermediate layer 4 is provided to improve the adhesive properties between the bonding layer 3 and the coating layer 2. It is acceptable if the amount of each of the components contained in the intermediate layer 4 is roughly uniform throughout the direction of the thickness of the layer. However, the intermediate layer 4 may be provided with a concentration distribution such that, the closer that portion of the intermediate layer 4 is to bonding layer 3, the more that the component content of intermediate layer 4 approaches the component content of the bonding layer 3, and, the closer that portion of the intermediate layer 4 is to coating layer 2, the more that the component content of the intermediate layer 4 approaches the component content of the coating layer 2. In this case, the compatibility between the bonding layer 3 and the coating layer 2 becomes better and the adhesive properties between the layers is further improved, so that this is preferable.

Moreover, in the preceding first through third embodiments, the bonding layer 3, the intermediate layer 4 and the coating layer 2 are formed using a physical vapor deposition method such as ion plating, high-frequency sputtering or the like. High- frequency sputtering is useful as it enables easy formation of a thin nitride layer, and this physical vapor deposition method can be used to form a coating that is highly hard and has a high oxidation initiation temperature. On the other hand, ion plating methods, and particularly from among these, arc ion plating methods, enable formation of a coating that is highly hard, has a high oxidation initiation temperature and superior adhesive properties (resistance to wear). Accordingly, when forming the high hardness coatings 10, 11, 12 of the surface-coated article that is used in machine tools and the like, it is preferable to form the coating using an ion plating method, and particularly, an arc ion plating method.

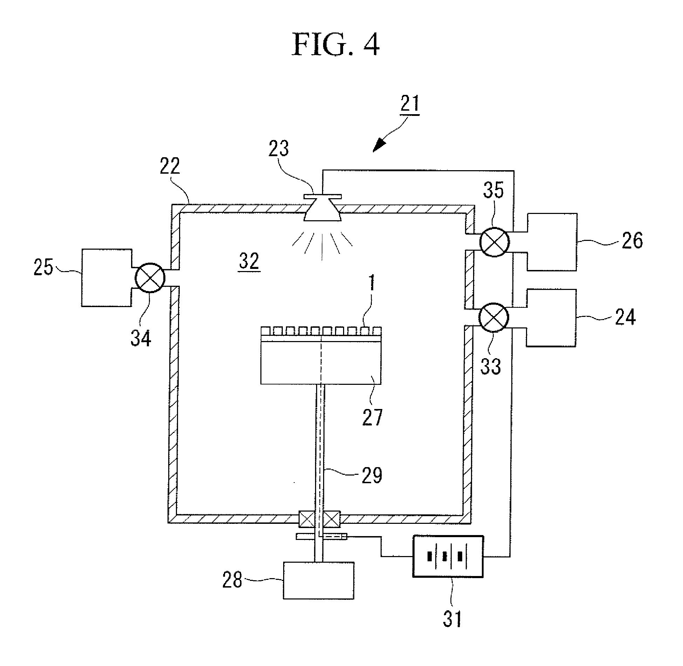

FIG. 4 is an overview of the arc ion plating device 21 for forming the high hardness coatings 10, 11, 12 to the surface of the base material in the first through third embodiments. This arc ion plating device 21 is provided with a casing 22 that is air-tight with respect to the atmosphere. A target 23 is disposed to the top part thereof, and a cable-shaped holder 27 is disposed to the chamber inside 32 of the casing 22. This holder 27 is connected to a motor 28 via a rotating axis 29, with holder 27 capable of circumferential rotation. A direct current power source 31 is connected between the target 23 and the holder 27, with target 23 connected to the positive side of the power source 31, and holder 27 connected to the negative side of the power source 31. FIG. 4 schematically shows the case where there is just one target 23, however, it is also possible to provide two or more targets 23 as necessary. In this case, the two or more targets 23 are disposed roughly equidistance from the holder 27.

A vacuum pump 24 for evacuating the chamber inside 32 is connected to the chamber inside 32 of the casing 22 via a control valve 33. In addition, an argon gas source 25 for supplying an inert gas to the chamber inside 32 is connected via a control value 34 to the chamber inside 32. Further, a nitrogen gas source 26 for supplying nitrogen to the chamber inside 32 is connected to the chamber inside 32 via a control valve 35.

In each of the preceding embodiments, the coating is formed after adjusting the type and number of targets 23. When forming the coating layer 2 in the first through third embodiments, an alloy consisting of, for example, Al and Zr, or Al, Zr and Si, is employed in the target 23. JIS SKH-51, which is a high-speed tool steel, or JIS TH-10, which is a carbide material, can be used for the base material 1, for example. When forming the bonding layer 3 in the second and third embodiments, pure zirconium (Zr: 100%), pure titanium (Ti: 100%) or pure chromium (Cr: 100%) is employed for target 23. Further, when forming the intermediate layer 4 in the third embodiment, typically a plurality of targets 23 are disposed, with at least one target 23 from among these consisting of the same metal as the target 23 for forming the bonding layer 3, and at least one of the other targets 23 consisting of the same alloy as the target 23 for forming the coating layer 2 of the outer surface.

The base material 1 is mounted on the holder 27. Control valves 33,34 are opened first from among the control valves 33-35. As a result, argon gas is supplied into chamber 32, while at the same time chamber 32 is evacuated. Once the evacuation is complete and an argon atmosphere has been created inside the chamber 32, the holder 27 is rotated by the motor 28. Next, the control valves 33,34 are closed, and a direct voltage is impressed between the target 23 and the holder 27, generating plasma and causing the temperature inside chamber 32 to rise. When the temperature inside chamber 32 reaches a constant value, the control valve 35 is opened and nitrogen gas is supplied from the nitrogen gas source 26 into the chamber 32, causing an arc discharge to be produced. As a result, each of the layers are formed onto the surface of the base material 1, and high hardness coatings 10,11,12 having superior resistance to high temperature oxidation are obtained.

Note that in each of the preceding embodiments, a layer consisting of a nitride of at least one type of element from among Zr, Ti, Cr and the like was employed for the bonding layer 3. However, it is believed that the same effects can be obtained if a layer consisting of a carbide or a carbonitride of the same elements, or a mixed phase containing two or more types of nitride, carbide and carbonitride of the same elements, is employed for the bonding layer 3 instead. In this case, a hydrocarbon may be supplied in place of, or together with, the nitrogen into the chamber 32 when forming the bonding layer 3.

A cutting tool or die in which a high-speed tool steel, cemented carbide or the like is employed as the base material 1 and the above-described high hardness coatings 10, 11, 12 are coated onto the surface of this base material 1 is highly hard and has excellent resistance to oxidation and wear. Moreover, a cutting tool that is suitable for dry cutting applications in which a cutting oil is not used can be obtained. Geared machine tools such as a hob cutter, pinion cutter, broach or the like, in which a high-speed tool steel or carbide material is employed for the base material 1 for example, may be cited as an example of this type of cutting tool. The aforementioned machine tools are employed by attaching to a gear hobbing machine or other such machine tool.

### (Examples and Comparative Examples)

The present invention will now be explained in greater detail using examples and comparative examples.

### Vickers hardness:

### (Sample Nos. A1-A12, S1 and R1-R3)

Nitride powders selected from AlN, ZrN, Si₃N₄, TiN and CrN were measured and mixed so that the compositional ratio of the electropositive elements had the values as shown in Table 1. These nitride powder mixtures were treated for 5 hours at 1200°C in a nitrogen atmosphere, to prepare compound nitride sintered compacts. Using this sintered compact as the target, a high-frequency sputtering method was then used to form a compound nitride coating to a coating thickness of approximately 4 µm onto a cemented carbide (TH-10) base material at a base material temperature of 250°C. The Vickers hardness (Hv) of the compound nitride coating was measured using a Vickers hardness tester. These results are shown in Table 1.

### (Sample No. M1)

Al, Pd and Si powders were each measured out and mixed so that the compositional ratio of the electropositive elements had the values shown in Table 1, and the mixture thereof was formed into a molded article. Using this molded article as a target, a high-frequency sputtering method was then used to form a compound nitride coating to a coating thickness of approximately 4 m onto a base material at a base material temperature of 250°C. The Vickers hardness (Hv) of the compound nitride coating was measured using a Vickers hardness tester. These results are shown in Table 1.

### (Sample No. M2)

Al, Ir and Si powders were each measured out so that the compositional ratio of the electropositive elements had the values shown in Table 1, and the mixture thereof was formed into a molded article. Using this molded article as a target, a high-frequency sputtering method was then used under a nitrogen atmosphere to form a compound nitride coating to a coating thickness of approximately 4 µm onto a base material at a base material temperature of 250°C. The Vickers hardness (Hv) of the compound nitride coating was measured using a Vickers hardness tester. These results are shown in Table 1.

### (Sample No. M3)

Al, Er and Si powders were each measured out so that the compositional ratio of the electropositive elements had the values shown in Table 1, and the mixture thereof was formed into a molded article. Using this molded article as a target, a high-frequency sputtering method was then used under a nitrogen atmosphere to form a compound nitride coating to a coating thickness of approximately 4 µm onto a base material at a base material temperature of 250°C. The Vickers hardness (Hv) of the compound nitride coating was measured using a Vickers hardness tester. These results are shown in Table 1.

### (Sample No. M4)

Al, Ho and Si powders were each measured out so that the compositional ratio of the electropositive elements had the values shown in Table 1, and the mixture thereof was formed into a molded article. Using this molded article as a target, a high-frequency sputtering method was then used under a nitrogen atmosphere to form a compound nitride coating to a coating thickness of approximately 4 µm onto a base material at a base material temperature of 250°C. The Vickers hardness (Hv) of the compound nitride coating was measured using a Vickers hardness tester. These results are shown in Table 1.

### (Sample No. M5)

A1, Dy and Si powders were each measured out so that the compositional ratio of the electropositive elements had the values shown in Table 1, and the mixture thereof was formed into a molded article. Using this molded article as a target, a high-frequency sputtering method was then used under a nitrogen atmosphere to form a compound nitride coating to a coating thickness of approximately 4 µm onto a base material at a base material temperature of 250°C. The Vickers hardness (Hv) of the compound nitride coating was measured using a Vickers hardness tester. These results are shown in Table 1.

### Resistance to oxidation:

### (Sample Nos. A1-A11, S1 and R1-R2)

A nitride powders selected from AlN, ZrN, Si₃N₄, TiN and CrN were measured out and mixed so that the compositional ratio of the electropositive elements had the values as shown in Table 1. This nitride powder mixture was treated for 5 hours at 1200°C in a nitrogen atmosphere, to prepare compound nitride sintered compacts. Using this sintered compact as the target, a high-frequency sputtering method was then used to form a compound nitride coating to a coating thickness of approximately 4 µm onto a Pt thin plate base material (10 x 5 x 0.1 mm) at a base material temperature of 250°C. The obtained sample pieces (Pt base material to which a compound nitride coating is formed) were then heated to 1400°C using a thermogravimeter with the temperature rising at a the rate of 10°C/min. The change in mass from heating and the oxidation initiation temperature were measured. These results are shown in Table 1.

### (Sample No. M1)

Al, Pd and Si powders were each measured out so that the compositional ratio of the electropositive elements had the value shown in Table 1, and the mixture thereof was formed into a molded article. Using this molded article as a target, a high-frequency sputtering method was then used in a nitrogen atmosphere to form a compound nitride coating to a coating thickness of approximately 4 µm onto a Pt thin plate base material (10 x 5 x 0.1 mm) at a base material temperature of 250°C. The obtained sample piece (Pt base material to which a compound nitride coating is formed) was then heated to 1400°C using a thermogravimeter with the temperature increasing at a rate of 10°C/min. The change in mass from heating and the oxidation initiation temperature were measured. The results are shown in Table 1.

### (Sample No. M2)

Al, Ir and Si powders were each measured out so that the compositional ratio of the electropositive elements had the value shown in Table 1, and the mixture thereof was formed into a molded article. Using this molded article as a target, a high-frequency sputtering method was then used in a nitrogen atmosphere to form a compound nitride coating to a coating thickness of approximately 4 µm onto a Pt thin plate base material (10 x 5 x 0.1 mm) at a base material temperature of 250°C. The obtained sample piece (Pt base material to which a compound nitride coating is formed) was then heated to 1400°C using a thermogravimeter with the temperature increasing at a rate of 10°C/min. The change in mass from heating and the oxidation initiation temperature were measured. The results are shown in Table 1.

### (Sample No. M3)

Al, Er and Si powders were each measured out so that the compositional ratio of the electropositive elements had the value shown in Table 1, and the mixture thereof was formed into a molded article. Using this molded article as a target, a high-frequency sputtering method was then used in a nitrogen atmosphere to form a compound nitride coating to a coating thickness of approximately 4 µm onto a Pt thin plate base material (10 x 5 x 0.1 mm) at a base material temperature of 250°C. The obtained sample piece (Pt base material to which a compound nitride coating is formed) was then heated to 1400°C using a thermogravimeter with the temperature increasing at a rate of 10°C/min. The change in mass from heating and the oxidation initiation temperature were measured. The results are shown in Table 1.

### (Sample No. M4)

Al, Ho and Si powders were each measured out so that the compositional ratio of the electropositive elements had the value shown in Table 1, and the mixture thereof was formed into a molded article. Using this molded article as a target, a high-frequency sputtering method was then used in a nitrogen atmosphere to form a compound nitride coating to a coating thickness of approximately 4 µm onto a Pt thin plate base material (10 x 5 x 0.1 mm) at a base material temperature of 250°C. The obtained sample piece (Pt base material to which a compound nitride coating is formed) was then heated to 1400°C using a thermogravimeter with the temperature increasing at a rate of 10°C/min. The change in mass from heating and the oxidation initiation temperature were measured. The results are shown in Table 1.

### (Sample No. M5)

A1, Dy and Si powders were each measured out so that the compositional ratio of the electropositive elements had the value shown in Table 1, and the mixture thereof was formed into a molded article. Using this molded article as a target, a high-frequency sputtering method was then used in a nitrogen atmosphere to form a compound nitride coating to a coating thickness of approximately 4 µm onto a Pt thin plate base material (10 x 5 x 0.1 mm) at a base material temperature of 250°C. The obtained sample piece (Pt base material to which a compound nitride coating is formed) was then heated to 1400°C using a thermogravimeter with the temperature increasing at a rate of 10°C/min. The change in mass from heating and the oxidation initiation temperature were measured. The results are shown in Table 1.

**Table 1**

| Vickers hardness Hv and oxidation initiation temperature of compound nitride coatings | | | | |
|---|---|---|---|---|
| | Sample No. | Composition | Vickers hardness (Hv) | Oxidation initiation temperature (°C) |
| | A1 | 0.6Al-0.3Zr-0.1Si-N | 2800 - 3500 | 1315 |
| | A2 | 0.5Al-0.4Zr-0.1Si-N | 2900 - 3600 | 1330 |
| | A3 | 0.7Al-0.2Zr-0.1Si-N | 2500 - 3000 | 1310 |
| | A4 | 0.4Al-0.5Zr-0.1Si-N | 2900 - 3600 | 1330 |
| | A5 | 0.3Al-0.6Zr-0.1Si-N | 2500 - 3000 | 1250 |
| | A6 | 0.8Al-0.1Zr-0.1Si-N | 2300 - 2700 | 1305 |
| Example | A7 | 0.85Al-0.05Zr-0.1Si-N | 2100 - 2600 | 1290 |
| | A8 | 0.5A1-0.3Zr-0.2Si-N | 2500 - 3100 | 1320 |
| | A9 | 0.4Al-0.3Zr-0.3Si-N | 2200 - 2700 | 1315 |
| | A10 | 0.3Al-0.3Zr-0.4Si-N | 1800 - 2500 | 1280 |
| | A11 | 0.69Al-0.3Zr-0.01Si-N | 2600 - 3200 | 1300 |
| | A12 | 0.65Al-0.3Zr-0.05Si-N | 2600 - 3300 | 1310 |
| | S1 | 0.7Al-0.3Zr-N | 2700 - 3300 | 1270 |
| | R1 | Ti-N | 1500 - 2000 | approx. 500 |
| Comp. Example | R2 | 0.5Ti-0.5A1-N | 2000 - 2500 | approx. 800 |
| | R3 | 0.6Al-0.3Cr-0.1Si-N | 2200 - 2800 | 1200 |
| | M1 | 0.6Al-0.3Pd-0.1Si-N | 2500 - 3500 | 1315 |
| | M2 | 0.6Al-0.3Ir-0.1Si-N | 2600 - 3600 | 1313 |
| Example | M3 | 0.6Al-0.3Er-0.1Si-N | 2800 - 3400 | 1312 |
| | M4 | 0.6Al-0.3Ho-0.1Si-N | 2900 - 3300 | 1310 |
| | M5 | 0.6Al-0.3Dy-0.1Si-N | 2800 - 3600 | 1319 |

As may be understood from the results of measurements of the hardness and oxidation initiation temperatures of the compound nitride coatings shown in Table 1, when the amount of included Zr is in the range of 10 to 50%, the obtained coating has a Vickers hardness equal to or greater than that of an AlCrSiN-based coating (R3), and an oxidation initiation temperature of 1250°C or more. When the amount of included Zr is less than 10%, the hardness is low. On the other hand, when the amount of included Zr is greater than 50%, it was noted that there tended to be a deterioration in resistance to oxidation. When the amount of Si contained was less than 1%, the adhesive strength became poor. In contrast, when the amount of Si contained was greater than 30%, resistance to oxidation and adhesive properties tended to be inadequate.

In addition, from the above results it may be understood that an excellent Vickers hardness and oxidation initiation temperature can be obtained even if a portion of the Zr is substituted with Pd, Ir, Er, Ho or Dy.

Further, since the free energy of formation of HfN is slightly greater than that of ZrN, HfN is more stable than ZrN. For this reason, the oxidation initiation temperature of a Hf-containing nitride in which Zr has been substituted with Hf is expected to be higher than a Zr-containing nitride, and should be superior with respect to both hardness and the oxidation initiation temperature.

## Claims

1. A surface-coated article comprising a base material (1) and a high hardness coating that is formed on or over said base material (1), wherein said high hardness coating comprises a coating layer (2) that contains a compound nitride that employs as main components Al and at least one element selected from the group consisting of Zr, Hf, Pd, Ir and the rare earth elements.

2. The surface-coated article according to claim 1, wherein the electropositive element component of the compound nitride in said coating layer (2) contains said at least one element selected from the group consisting of Zr, Hf, Pd, Ir and the rare earth elements in the range of 10 to 50 atomic percent, with the balance comprising Al and unavoidable impurities.

3. The surface-coated article according to claim 1, wherein said compound nitride of said coating layer (2) additionally has as its main components Si.

4. The surface-coated article according to claim 3, wherein the electropositive element component of the compound nitride in said coating layer (2) contains said at least one element selected from the group consisting of Zr, Hf, Pd, Ir and the rare earth elements in the range of 10 to 50 atomic percent, and Si in the range of 1 to 30 atomic percent, with the balance comprising Al and unavoidable impurities.

5. The surface-coated article according to any one of claims 1 to 4, comprising a bonding layer (3) that is provided between said base material (1) and said coating layer (2), said bonding layer (3) containing at least one of nitrides, carbides, and carbonitrides of at least one type of element selected from the group consisting of Zr, Ti and Cr.

6. The surface-coated article according to claim 5, comprising an intermediate layer (4) that is provided between said bonding layer (3) and said coating layer (2), said intermediate layer (4) containing a component of said bonding layer (3) and a component of said coating layer (2).

7. The surface-coated article according to any one of claims 1 to 6, wherein said base material (1) is a high-speed tool steel or a cemented carbide.

8. A production method for a surface-coated article, comprising:
supporting a base material (1) inside an airtight container (22) by a holder (27) disposed therein;
disposing a target (23) for forming a coating layer (2) containing an alloy or nitride thereof having as main components Al and at least one type of element selected from the group consisting of Zr, Hf, Pd, Ir and the rare earth elements, inside said container (22);
supplying nitrogen into said container (22); and
obtaining a surface-coated article provided with said base material (1) and said coating layer (2) by employing said target (23) for forming said coating layer (2) as the anode and employing said holder (27) as the cathode, generating an electrical discharge between said holder (27) and said target (23) for forming said coating layer (2), and causing a coating layer (2) to be formed onto said base material (1).

9. The production method for a surface-coated article according to claim 8, wherein the electropositive element component of the compound nitride in said coating layer (2) contains said at least one element selected from the group consisting of Zr, Hf, Pd, Ir and the rare earth elements in the range of 10 to 50 atomic percent, with the balance comprising Al and unavoidable impurities.

10. The production method for a surface-coated article according to claim 8, wherein the step of disposing the target (23) comprises disposing a target (23) for forming the coating layer (2) containing the alloy or nitride thereof having as additional main components Si.

11. The production method for a surface-coated article according to claim 10, wherein the electropositive element component of the compound nitride in said coating layer (2) contains said at least one element selected from the group consisting of Zr, Hf, Pd, Ir and the rare earth elements in the range of 10 to 50 atomic percent, and Si in the range of 1 to 30 atomic percent, with the balance comprising A1 and unavoidable impurities.

12. The production method for a surface-coated article according to any one of claims 8 to 11, comprising:
disposing a target for forming a bonding layer (3) containing as a main component at least one element selected from the group consisting of Zr, Ti and Cr inside said container (22);
supplying at least one of nitrogen and hydrocarbons into said container (22); and
forming a bonding layer (3) onto said base material (1) supported by said holder (27) by employing said target for forming said bonding layer (3) as the anode and employing said holder (27) as the cathode, and generating an electrical discharge between said holder (27) and said target for forming said bonding layer (3), and forming said coating layer (2) onto said bonding layer (3).

13. The production method for a surface-coated article according to claim 12, wherein, after forming said bonding layer (3), an intermediate layer (4) is formed onto said bonding layer (3) by employing said target for forming said bonding layer (3) and said target for forming said coating layer (2) as the anodes and employing said holder (27) as the cathode, and generating an electrical discharge between said holder (27) and said target for forming said bonding layer (3) and said target for forming said coating layer (2) respectively, and forming said coating layer (2) on top of said intermediate layer (4).

14. A machine tool comprising a base material (1) used for machine tools and a high hardness coating which is formed on or over said machine tool base material (1), wherein said high hardness coating comprises a coating layer (2) that contains a compound nitride that employs as main components Al and at least one element selected from the group consisting of Zr, Hf, Pd, Ir and the rare earth elements.

15. The machine tool according to claim 14, wherein said compound nitride of said coating layer (2) additionally employs as main components Si.

16. A machine tool apparatus comprising a machine tool as defined in claim 14 or 15.
